Europäisches Patentamt

European Patent Office

. Office européen des brevets

(11) Veröffentlichungsnummer: **0 308 676**
**A2**

## (12) EUROPÄISCHE PATENTANMELDUNG

(21) Anmeldenummer: 88113887.9

(22) Anmeldetag: 25.08.88

(51) Int. Cl.4 **H05K 5/06 , H01L 25/16**

(30) Priorität: 25.09.87 DE 3732462

(43) Veröffentlichungstag der Anmeldung:
29.03.89 Patentblatt 89/13

(84) Benannte Vertragsstaaten:
DE FR GB IT NL

(71) Anmelder: **Siemens Aktiengesellschaft Berlin und München**
**Wittelsbacherplatz 2**
**D-8000 München 2(DE)**

(72) Erfinder: **Leute, Ulrich, Dr. rer. nat.**
**Herzogplatz 18**
**D-8011 Zorneding(DE)**
Erfinder: **Criens, Ralf, Dipl.-Ing.**
**Stengelstrasse 2**
**D-8000 München 40(DE)**
Erfinder: **Otto, Peter, Dr.-Ing.**
**Weinbergerstrasse 55**
**D-8000 München 60(DE)**

(54) Spannungsarme Umhüllung für elektrische und elektronische Bauelemente, insbesondere Hybridschaltungen.

(57) Es wird eine Umhüllung für elektrische und elektronische Bauelemente, insbesondere für Hybridschaltungen, zum Schutz gegen Umgebungseinflüsse vorgeschlagen, wobei unter einer harten, mechanisch und chemisch stabilen äußeren Schutzschicht (5) noch eine elastische und kompressible Zwischenschicht (3) vorgesehen ist. In einem Verfahren zur Herstellung der Umhüllung werden die kompressiblen Bereiche (4) durch Einrühren von Gasblasen oder Mikrohohlkugeln in die die Zwischenschicht (3) bildende Kunststoffmasse oder durch chemische Freisetzung von Gasblasen in der Kunststoffmasse erzeugt.

Durch die zweischichtige Ausführung der Erfindung wird das Bauelement spannungsarm umhüllt und vor Schäden bei Dimensionsänderungen der Umhüllung durch Reaktionsschwund beim Aushärten der Umhüllung oder durch starke Temperaturwechsel geschützt.

## Spannungsarme Umhüllung für elektrische und elektronische Bauelemente, insbesondere Hybridschaltungen.

Die Erfindung betrifft eine Umhüllung für elektrische und elektronische Bauelemente, insbesondere Schaltungen in Hybridtechnik zum Schutz gegen Umgebungseinflüsse, sowie ein Verfahren zu ihrer Herstellung.

Schaltungen der Industrie-, KFZ- oder Flugzeugelektronik werden im zivilen und insbesondere auch im militärischen Bereich zum Schutz gegen Umgebungseinflüsse, wie Feuchtigkeit, aggressive Chemikalien, mechanische Belastungen, zum Beispiel durch Stoß oder auch nur gegen den Einblick von Unbefugten mit Kunststoffmassen umhüllend vergossen.

Für diese vergossenen Umhüllungen werden üblicherweise Reaktionsharze, zum Beispiel auf Epoxid oder Phenolharzbasis verwendet. Bei der Härtung der Harze tritt allerdings oft ein Volumenschwund auf, der beim zu schützenden Bauelement bzw. der Schaltung zu Verspannungen und infolge dessen zum Abriß von Leiterbahnen, Bond- oder Lötstellen, bei Hybridschaltungen auch zum Bruch des Substrats, und somit zu Schädigungen des Bauteils führen kann. Durch Verwendung eines Füllstoffes im Harz werden Vergußmassen mit geringem Reaktionsschwund erhalten. Üblicherweise wird wegen seiner elektrisch isolierenden Eigenschaften Quarz als Füllstoff verwendet.

Ein weiteres Problem beim Umhüllen von elektrischen und elektronischen Bauteilen tritt durch die unterschiedlichen thermischen Ausdehnungskoeffizienten von Schaltungsbestandteilen und Vergußmassen auf. Sowohl bei äußeren umgebungsbedingten Temperaturschwankungen, als auch bei der durch die elektrische Verlustwärme auftretenden Erhitzung sind die Bauteile Dimensionsänderungen ausgesetzt, die bei unterschiedlichen thermischen Ausdehnungskoeffizienten zu Verspannungen und Beschädigungen des Bauelements führen können.

Zur Verringerung der mechanischen Spannungen sind niedrige Werte sowohl für den Ausdehnungskoeffizienten, als auch für den Elastizitätsmodul des Harzes bzw. der Umhüllung gefordert.

Die genanten Anforderungen lassen sich allerdings nur schwer gleichzeitig bzw. in einer Vergußmasse erfüllen. Gefüllte Harze besitzen in der Regel einen hohen Modul, flexible Harze dagegen einen hohen Ausdehnungskoeffizienten. Nachteilig ist weiterhin, daß hochgefüllte Harze schwer verarbeitbar und flexible Harze oft wenig chemikalienbeständig sind.

Aufgabe der Erfindung ist es daher, eine Umhüllung für elektronische und elektrische Bauelemente anzugeben, die die Bauelemente gegen Umgebungseinflüsse schützt, das Auftreten von mechanischen Spannungen zwischen Umhüllung und Bauteil vermeidet und dabei gleichzeitig leicht zu verarbeiten ist.

Diese Aufgabe wird durch eine Umhüllung der eingangs genannten Art erfindungsgemäß dadurch gelöst, daß zur Umhüllung unter einer mechanisch und chemisch stabilen äußeren Schicht noch eine elastische und kompressible Zwischenschicht auf dem Bauteil vorgesehen ist.

Weitere Ausgestaltungen der Erfindung, sowie ein Verfahren zur Herstellung der Umhüllung sind den Unteransprüchen zu entnehmen.

Die kompressible Zwischenschicht besteht aus einem flexiblen Kunststoff mit niedrigem Elastizitätsmodul, der einen mikrozellularen Aufbau und somit kompressible Bereiche aufweist.

Ein mikrozellularer Aufbau wird durch den Einbau von Gasblasen oder durch die Verwendung eines syntaktischen Schaums mit deformierbaren Hohlkugeln erreicht.

Der Einbau von Gasblasen kann physikalisch durch Einblasen oder Einrühren von Gas in die flexible Kunststoffmasse vor dem Aufbringen der Schicht und dem anschließenden Aushärten erfolgen.

Bessere Reproduzierbarkeit wird durch chemische Freisetzung von Gasen direkt in der Kunststoffmasse vor oder während der Aushärtung erreicht. Beispielsweise führt die Zugabe einer geringen Menge Wasser zu den Komponenten eines Polyurethan-Kunststoffs zu einer Abspaltung von Kohlendioxid und somit zu einem Aufschäumen des Kunststoffs.

Eine andere Möglichkeit bietet der Zusatz von Treibmitteln zu der Kunststoffmasse. Diese nicht an der Härtungsreaktion der Kunststoffmasse beteiligten Verbindungen vermögen ähnlich wie ein Backtreibmittel durch die für die Härtung des Kunststoffes nötigen erhöhten Temperaturen Gase abzuspalten oder gänzlich in gasförmige Produkte zu zerfallen. Bei nicht thermisch härtenden Kunststoffmassen ist auch eine photochemisch induzierte Gasabspaltung aus lichtinstabilen Treibmitteln denkbar.

Noch bessere Reproduzierbarkeit wird erreicht, wenn die kompressiblen Bereiche bereits vorgefertigt sind und in die Kunststoffmasse vor dem Aufbringen auf das Bauteil eingerührt werden. Dazu können deformierbare Mikrohohlkugeln verwendet werden, zum Beispiel PVCD-Kugeln mit einem mittleren Durchmesser von ca. 40 μm.

Für die gewünschten Eigenschaften der erfindungsgemäßen Zwischenschicht ist es nötig, daß der mikrozellulare Aufbau der elastisch-kompressiblen Zwischenschicht einen niedrigen Porendurchmesser, vorteilhafterweise um ca. 50 μm aufweist. Weiterhin soll die Anzahl der Hohlkörper bzw. Gasblasen in der Zwischenschicht nicht zu hoch sein, um eine ausreichende Wärmeleitfähigkeit dieser Zwischenschicht zu gewährleisten. Aus dem gleichen Grund, nämlich um die Verlustwärme des Bauteils beim Betrieb gut nach außen abführen zu können, darf die Zwischenschicht auch nicht zu dick sein. Für eine ausgewählte Dickschichthybridschaltung wurde zum Beispiel eine für gute Wärmeableitung maximal zulässige Dicke der Zwischenschicht von 300 μm errechnet. Für andere Bauelemente kann die optimale Dicke der Zwischenschicht jedoch nur im Zusammenhang mit diesem Bauelement und den verwendeten Kunststoffmaterialien für die Umhüllung bestimmt werden und kann deshalb auch stark von diesem errechneten Wert abweichen. Wird zum Beispiel eine Schaltung nur auf einer Seite des Substrats umhüllt, so kann die Wärme noch über die Rückseite des zum Beispiel aus Aluminiumoxid bestehenden Substrats abgeführt werden, und die Zwischenschicht deshalb in einer größeren Schichtdicke aufgebracht werden.

Eine weitere Anforderung an die Kunststoffmasse für die Zwischenschicht ist deren gute Verarbeitbarkeit. Entsprechend den Aufbringungsmethoden der Kunststoffmasse auf die Bauelemente darf die Masse nicht zu viskos sein.

Geeignete Kunststoffe für die Zwischenschicht sind zum Beispiel flexible Zweikomponenten-Silikonkautschuke, UV-härtbare Silikonkautschuke, Epoxidharze oder zwei Komponenten-Polyurethansysteme. Sofern die oben erwähnten Bedingungen wie Flexibilität, ausreichend dünnflüssige Beschaffenheit und außerdem eine Glasübergangstemperatur, die unter den tiefsten zu erwartenden Einsatztemperaturen des Bauelements (ca. - 25 °C) liegt, erfüllt werden, sind jedoch auch andere Kunststoffsysteme denkbar. Auch sollte der verwendete Kunststoff ausscheidungsarm und insbesondere ionenarm sein, um eine Beschädigung des Bauelements mittels einer durch die Ausscheidungen initiierten Korrosion zu vermeiden.

Besondere wirtschaftliche Vorteile bei der Umhüllung ergeben sich bei der Verwendung von schnellhärtenden UV-Silikonkautschuken für die kompressible Zwischenschicht. In einem Versuch wurde zum Beispiel mit einem Kautschuk eine Aushärtzeit von 10 Sekunden erzielt. Thermisch härtende Kunststoffmassen benötigen in der Regel mindestens das Hundertfache an Aushärtzeit, in einigen Fällen sogar bis zu mehreren Stunden.

Zum Aufbringen der Zwischenschicht eignen sich die verschiedensten Verfahren. Ist eine allseitige Umhüllung des Bauelements vorgesehen, kann dies zum Beispiel durch Tauchen geschehen. Dafür muß allerdings ein dünnflüssiges System gewählt werden. Weitere Aufbringverfahren sind beispielsweise Aufsprühen, Auftragen mit einem Pinsel oder Aufdosieren (Dispenser).

Letzteres kann zum Beispiel durch mäanderförmiges und somit flächendeckendes Auftragen mit einer Hohlnadel oder auch über eine schlitzförmige Düse erfolgen.

Über der ausgehärteten Zwischenschicht wird eine mechanisch und chemisch stabile äußere Schicht als eigentliche Schutzschicht vorgesehen. Diese Schicht muß nun bedeutend geringere Anforderungen bezüglich des Volumenschwunds und des thermischen Ausdehnungskoeffizienten erfüllen als bei herkömmlicher Umhüllungstechnik. Auch kann das dafür verwendete und (bevorzugt durch Vergießen) leicht verarbeitbare Harz der Schutzschicht einen hohen Elastizitätsmodul aufweisen. Dadurch wird auch die Verwendung anderer Kunststoffe als Gießharze für die Schutzschicht ermöglicht.

Die mit der erfindungsgemäßen Umhüllung versehenen Bauteile, insbesondere Hybridschaltungen, weisen eine gegenüber herkömmlicher Umhüllung stark erhöhte Temperaturwechselbeständigkeit auf. Bei Temperaturzyklen zwischen - 25 ° und + 100 °C weisen sie eine deutlich geringere Ausfallquote auf. Durch die niedrigeren Anforderungen an die physikalischen Parameter der Schutzschicht ist die Auswahl der verwendbaren Harze, Kunststoffe und auch Füllstoffe bedeutend umfangreicher. Bei gleicher Qualität der Umhüllung können deshalb auch preiswertere und schneller härtende Kunststoffe eingesetzt werden, woraus sich zusätzliche wirtschaftliche Vorteile der erfindungsgemäßen Umhüllung ergeben.

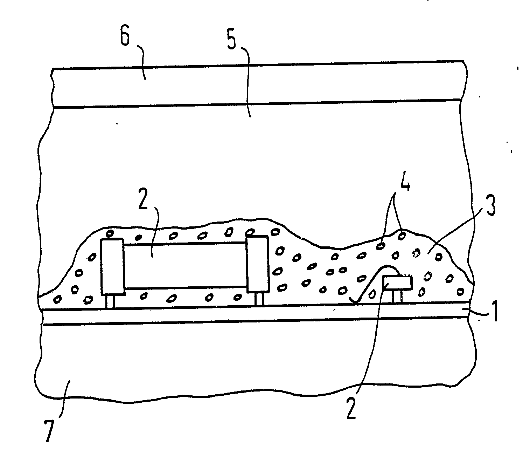

Im folgenden wird die Erfindung anhand der Figur und zweier Ausführungsbeispiele noch näher erläutert. Dabei zeigt die Figur eine erfindungsgemäß umhüllte Schaltung im Querschnitt.

Figur: Auf einem mit Leiterbahnen versehenen und zum Beispiel aus Aluminiumoxid bestehenden Substrat 1 befinden sich verschiedene Bauelemente 2, zum Beispiel Transistoren, Widerstände usw., die gebondet oder gelötet sind. Darüber ist die Zwischenschicht 3 aufgebracht, die kompressible Bereiche 4 enthält. Die Bauelemente 2 sind vollständig von der Zwischenschicht 3 bedeckt. Ebenso sind alle zugänglichen Zwischenräume zwischen und unter den Bauelementen 2 mit dem im dünnflüssigen Zustand aufgebrachten Kunststoff der Zwischenschicht 3 ausgefüllt. Darüber wird eine üblicherweise aus Gießharz bestehende und die Schaltung vor äußeren Einflüssen schützende Schicht 5 vergossen. Wahlweise kann zum weiteren Schutz noch ein Gehäuse 6 vorgesehen sein. In einigen Fällen kann eine ganzseitige Umhüllung des Bauelements bzw. der Schaltung vorteilhaft sein. In diesen Fällen wird auf die Unterseite des Substrats 1 eine weitere Schutzschicht 7 aufgebracht, die üblicherweise aus dem gleichen Material wie die Schicht 5 besteht.

## 1. Ausführungsbeispiel

Eine Hybridschaltung, die auf einem Aluminiumoxidsubstrat gelötete diskrete Bauelemente, gebondete ungehäuste integrierte Schaltungen sowie in Dickschichttechnologie aufgebrachte Leiterbahnen und Widerstände trägt, wird mit Polyurethan umhüllt. Zur Erzielung der Eigenschaft "elastisch und kompressibel" wird ein 2-Komponenten-Polyetherurethan ausgewählt (Fermapor K 31 432 der Firma Sonderhoff, Polyether: Diisocyanat = 3,5 : 1 Gewichtsteile) und mit einer Dosieranlage in einer Schicht von ca. 1 10 bis 5,10 mm Stärke, je nach Geometrie der Bauelemente, aufgebracht. Durch die Anwesenheit geringer Mengen Wasser (zum Beispiel Luftfeuchtigkeit) kommt es zur gewünschten Blasenbildung. Anschließend wird in bekannter Weise mit einem Harz vergossen. Die Zwischenschicht kann die Anzahl der Ausfälle nach Temperaturzyklen um 85 % senken.

## 2. Ausführungsbeispiel

In einen UV-härtenden Silikonkautschuk werden 13.3 Vol. % Mikrohohlkugeln (mittlerer Durchmesser 40 μm, Wand ca. 0.5 μm Durchmesser Polyvinylidenchlorid (PVDC), Firma Follmann & Co.) eingemischt. Das Produkt wird von Hand in ähnlichen Schichtdicken wie im ersten Ausführungsbeispiel aufgetragen und im UV-Licht gehärtet. Anschließend wird wie im ersten Ausführungsbeispiel mit Harz vergossen. Der Temperaturzykeltest nach dem vollstän digen Verguß ergibt eine Verringerung der Anzahl der Ausfälle um 70 %.

## Ansprüche

1. Umhüllung für elektrische und elektronische Bauelemente, insbesondere für Hybridschaltungen zum Schutz gegen Umgebungseinflüsse, **dadurch gekennzeichnet,** daß zur Umhüllung unter einer mechanisch und chemisch stabilen äußeren Schicht (5) noch eine elastische und kompressible Zwischenschicht (3) auf dem Bauteil vorgesehen ist.

2. Umhüllung nach Anspruch 1, **dadurch gekennzeichnet,** daß die kompressible Schicht (3) Gasblasen enthält.

3. Umhüllung nach Anspruch 1, **dadurch gekennzeichnet,** daß die kompressible Zwischenschicht (3) ein syntaktischer Schaum mit deformierbaren Mikrohohlkugeln ist.

4. Umhüllung nach mindestens einem der Ansprüche 1 bis 3, **dadurch gekennzeichnet,** daß der mittlere Porendurchmesser der die kompressiblen Bereiche (4) bildenden Gasblasen oder Mikrohohlkugeln unterhalb von 70 μm, vorzugsweise bei 50 μm liegt.

5. Umhüllung nach einem der Ansprüche 1 bis 4, **dadurch gekennzeichnet,** daß der flexible Kunststoff der Zwischenschicht (3) eine Glasübergangstemperatur unterhalb von - 25° C aufweist.

6. Umhüllung nach einem der Ansprüche 1 bis 5, **dadurch gekennzeichnet,** daß der flexible Kunststoff der Zwischenschicht (3) ein Zweikomponenten-Silikonkautschuk, ein UV-härtbarer Silikonkautschuk, ein Epoxidharz oder ein Zweikomponenten-Polyurethan-Kunststoff ist.

7. Verfahren zum Herstellen einer Umhüllung nach Anspruch 1, **dadurch gekennzeichnet,** daß

a) auf einem Bauelement eine Zwischenschicht (3) aus diesem flexiblen Kunststoff in dem kompressible Bereiche (4) vorgesehen werden, aufgebracht wird,

b) die Zwischenschicht (3) gehärtet wird und

c) über der Zwischenschicht (3) eine harte, chemisch und mechanisch stabile Schutzschicht (5) aus einem leicht verarbeitbaren Kunststoff aufgebracht wird.

8. Verfahren nach Anspruch 7, **dadurch gekennzeichnet,** daß die kompressiblen Bereiche (4) der Zwischenschicht (3) durch Einarbeiten von Gasblasen in den flexiblen Kunststoff vor dem Aufbringen auf das Bauelement erzeugt werden.

9. Verfahren nach Anspruch 7, **dadurch gekennzeichnet,** daß die kompressiblen Bereiche (4) durch Einmischen von deformierbaren Mikrohohlkugeln in den flexiblen Kunststoff vor dem Aufbringen auf das Bauelement erzeugt werden.

10. Verfahren nach Anspruch 7, **dadurch gekennzeichnet,** daß die kompressiblen Bereiche (4) aus Gasblasen bestehen, und diese durch chemische Freisetzung eines Gases in der Zwischenschicht (3) erzeugt werden.

11. Verfahren nach Anspruch 10, **dadurch gekennzeichnet,** daß das Gas aus dem flexiblen Kunststoff beigemischten chemischen Treibmitteln freigesetzt wird.

12. Verfahren nach Anspruch 10, **dadurch gekennzeichnet,** daß die kompressiblen Bereiche (4) durch die chemische Umsetzung eines Isocyanats mit Wasser erzeugt werden, wobei das Isocyanat gleichzeitig eine Komponente eines die Zwischenschicht (3) bildenden Polyurethankunststoffs ist.

13. Verfahren nach mindestens einem der Ansprüche 7 bis 12, **dadurch gekennzeichnet,** daß die Zwischenschicht (3) durch Tauchen, Sprühen, Pinselauftragung oder Aufdo sieren (Dispenser) aufgebracht wird.

14. Verfahren nach mindestens einem der Ansprüche 7 bis 13, **dadurch gekennzeichnet,** daß die Schutzschicht (5, 7) ganzseitig, das heißt sowohl über der Zwischenschicht (3) als auch auf die Unterseite des Substrats 1 aufgebracht wird.